# EUROPÄISCHE PATENTSCHRIFT

(11) **EP 3 766 120 B1**
(45) Veröffentlichungstag und Bekanntmachung des Hinweises auf die Patenterteilung: **24.11.2021**
(21) Anmeldenummer: 20726719.6
(22) Anmeldetag: 07.05.2020
(51) Int. Cl.: H01M 10/052, G01R 31/378, G01R 31/3842, G01R 31/392, H01M 10/48

(54) **CHARAKTERISIERUNG VON LITHIUM-PLATING BEI WIEDERAUFLADBAREN BATTERIEN**
CHARACTERISATION OF LITHIUM PLATING IN RECHARGEABLE BATTERIES
CARACTÉRISATION D'UN PLACAGE DE LITHIUM POUR DES BATTERIES RECHARGEABLES

(30) Priorität: 08.05.2019 DE 102019111958
(43) Veröffentlichungstag der Anmeldung: 20.01.2021
(73) Patentinhaber: TWAICE Technologies GmbH, 80807 München (DE)
(72) Erfinder: BAUMANN, Michael, 80805 München (DE)
(74) Vertreter: Neusser, Sebastian
(86) Internationale Anmeldenummer: PCT/EP2020/062690
(87) Internationale Veröffentlichungsnummer: WO 2020/225356

(56) Entgegenhaltungen:
- WO-A1-2011/128756
- DE-A1-102017 100 220
- MARK VERBRUGGE: "Adaptive, multi-parameter battery state estimator with optimized time-weighting factors", JOURNAL OF APPLIED ELECTROCHEMISTRY, KLUWER ACADEMIC PUBLISHERS, DO, Bd. 37, Nr. 5, 21. Februar 2007 (2007-02-21), Seiten 605-616, XP019502122, ISSN: 1572-8838, DOI: 10.1007/S10800-007-9291-7 in der Anmeldung erwähnt

## Beschreibung

### TECHNISCHES GEBIET

Verschiedene Beispiele der Erfindung betreffen Verfahren zur Charakterisierung einer wieder aufladbaren Batterie. Insbesondere betreffen verschiedene Beispiele der Erfindung Techniken zur Charakterisierung, um einen Lithium-Plating-Zustand einer Batterie zu bestimmen.

### HINTERGRUND

Wiederaufladbare Batterien, beispielsweise Traktions-Batterien von Elektrofahrzeugen, weisen eine begrenzte Lebensdauer auf. Ein Faktor, der die Lebensdauer von wiederaufladbaren Batterien beeinflussen kann ist sogenanntes Lithium-Plating, welches bei manchen wiederaufladbaren Batterien auftreten kann.

DE 10 2017 100220 A1 offenbart ein Fahrzeug, umfassend: eine Traktionsbatterie mit einer Vielzahl von Zellen; und eine Steuerung, die in Kommunikation mit der Traktionsbatterie steht und programmiert ist, um die Traktionsbatterie oder das Fahrzeug als Antwort auf eine Differenz zwischen einem Zielwert und einem aktuellen Wert eines Lithium-Plating-Indikators zu steuern.

WO 2011/128756 A1 offenbart Techniken, um einen Degradationszustand einer Lithium-Ionenbatterie zu bestimmen.

Verbrugge, Mark. "Adaptive, multi-parameter battery state estimator with optimized time-weighting factors." Journal of applied electrochemistry 37.5 (2007): 605-616 offenbart einen adaptiven Batterie-Steuerungsalgorithmus.

Unter Lithium-Plating wird hierbei verstanden, dass sich Lithium in metallischer Form an der Anode von wiederaufladbaren Batterien ablagert. Ein solches metallisches Ablagern kann die Eigenschaften der wiederaufladbaren Batterien negativ beeinflussen. Es kann zwischen reversiblem und irreversiblem Lithium-Plating unterschieden werden. Lithium-Plating sowie Laboruntersuchungen hierzu sind in Ratnakumar V. Bugga and Marshall C. Smart, "Lithium Plating Behavior in Lithium-Ion Cells", ECS Trans. 2010 volume 25, issue 36, 241-252, doi: 10.1149/1.3393860, beschrieben.

Ein Nachweisen von Lithium-Plating ist unter Laborbedingungen mit Hilfe von wohldefinierten Ladezyklen oder durch post mortem Analysen von Batteriezellen mittels aufwändigen Nachweisverfahren, beispielsweise Elektronenmikroskopaufnahmen bekannt. Eine in situ Bestimmung von Lithium Plating ist nur mit noch wesentlich aufwändigeren Methoden, beispielsweise Neutronendiffraktometrie, bekannt. Solche Nachweisverfahren sind während des Nutzbetriebs einer Batterie, beispielsweise während die Batterie zur Versorgung eines Fahrzeugs beim Kunden täglich verwendet wird, schwer oder gar nicht durchzuführen.

Zusätzlich zu diesen physikalischen Messungen gibt es Verfahren, bei denen Lithium-Plating anhand von charakteristischen Spannungsplateaus, die nach einer Ladephase aufgrund der nachfolgenden Oxidation von Lithium auftreten, nachgewiesen wird.

Solche Spannungsanomalien können relativ leicht während der Relaxation oder einer Konstantstrom-Entladung erkannt werden. Allerdings verschwinden diese Plateaus, wenn die Batterie-Entladung dynamisch erfolgt. Deshalb sind solche Messungen nur bedingt geeignet, im laufenden Betrieb - d.h. im Realbetrieb einer Feldeinheit einer Batterie - Lithium-Plating nachzuweisen.

### KURZE BESCHREIBUNG DER ERFINDUNG

Deshalb besteht der Bedarf nach weiteren Möglichkeiten zur Diagnose von Lithium-Plating. Insbesondere besteht ein Bedarf nach Möglichkeiten zur Detektion von Lithium Plating in realen Anwendungen, die überlagerte Dynamiken aufweisen.

Diese Aufgabe wird gelöst von den Merkmalen der unabhängigen Patentansprüche. Die Merkmale der abhängigen Patentansprüche definieren Ausführungsbeispiele.

Es wird ein Verfahren zur Charakterisierung einer wieder aufladbaren Batterie, die ein Risiko für Lithium-Plating aufweist, bereitgestellt. Das Verfahren umfasst: Empfangen von Betriebswerten der Batterie, wobei die Betriebswerte der Batterie umfassen: eine Klemmenspannung der Batterie und einen Batteriestrom der Batterie.

Die Betriebswerte werden als Zeitreihen empfangen. Eine nicht zur Erfindung gehörende Alternative wäre es, dass die Betriebswerte als aggregierte Daten empfangen werden. Beispielsweise können Histogramme verwendet werden.

### Das Verfahren umfasst ferner:

Bestimmen einer modellierten Klemmenspannung mit einem Modell der Batterie , basierend auf dem Batteriestrom,

Vergleichen der modellierten Klemmenspannung mit der Klemmenspannung, Bestimmen eines Lithium-Plating-Zustands der Batterie basierend auf dem Vergleichen.

Das Vergleichen kann auf instantanen Spannungswerten der Klemmspannung und der modellierten Klemmspannung beruhen. Ferner wäre es möglich, dass das Bestimmen der modellierten Klemmenspannung das Integrieren der modellierten Klemmenspannungen über einen bestimmten Bereich umfasst, wodurch sich eine modellierte Fläche ergibt. Die modellierte Fläche kann mit einer Fläche verglichen werden, die sich durch Integrieren der Klemmenspannungen über den bestimmten Bereich ergibt. Das bedeutet, dass das Vergleichen auf Integralen über Spannungswerte beruhen kann. Aus dem Vergleich der modellierten Fläche und der Fläche, die sich aus den Betriebswerten der Batterie ergibt, kann der Lithium-Plating-Zustand der Batterie bestimmt werden.

Unter einer Zeitreihe werden hierbei zeitliche Abfolge von Daten verstanden, welche beispielsweise durch eine Reihe von Messungen zu verschiedenen Zeitpunkten bestimmt werden können. Die zeitliche Abfolge kann hierbei kontinuierlich erfolgen, es kann aber auch möglich sein, dass die zeitliche Abfolge unregelmäßig ist.

Ein Computerprogramm oder ein Computerprogramm-Produkt oder ein Computer-lesbares Speichermedium umfasst Programmcode. Dieser Programmcode kann von einem Prozessor geladen werden und ausgeführt werden. Dies bewirkt, dass der Prozessor ein Verfahren zur Charakterisierung einer wiederaufladbaren Batterie gemäß einem der beschriebenen Verfahren durchgeführt wird. Das Verfahren kann hierbei serverseitig durchgeführt werden.

Ferner wird ein System bereitgestellt. Das System umfasst:
Mindestens eine Vorrichtung mit einer Batterie, wobei die Vorrichtung eingerichtet ist, Betriebswerte an einen Server zu übertragen, wobei die Betriebswerte umfassen:
eine Klemmenspannung der Batterie als Zeitreihe, und einen Batteriestrom der Batterie als Zeitreihe.

Das System umfasst ferner einen Server. Der Server ist eingerichtet, die Betriebswerte der mindestens einen Vorrichtung zu empfangen und damit die hier beschriebenen Verfahren auszuführen.

Bei der mindestens einen Vorrichtung kann es sich um ein Fahrzeug handeln.

Des Weiteren wird ein Server bereitgestellt. Der Server ist eingerichtet, Betriebswerte einer Batterie als Zeitreihe zu empfangen und damit die hier beschriebenen Verfahren auszuführen, wobei die Betriebswerte der Batterie deren Klemmenspannung und deren Batteriestrom umfassen.

### KURZE BESCHREIBUNG DER FIGUREN

Fig. 1 zeigt ein Verfahren gemäß verschiedener Ausführungsbeispiele.
Fig. 2 zeigt ein System gemäß verschiedener Ausführungsbeispiele.
Fig. 3 zeigt ein Beispiel einer Batterie, die eine Vorrichtung versorgt.
Fig. 4 zeigt ein Beispiel eines Servers.
Fig. 5 zeigt ein Beispiel einer elektrischen Schaltung umfassend eine wiederaufladbare Batterie.
Fig. 6 zeigt ein Beispiel einer Zeitreihe des Batteriestroms der Batterie
Fig. 7 zeigt eine mögliche Implementierung des Verfahrens der Fig. 1.
Fig. 8 zeigt einen Ersatzschaltkreis, der zum Modellieren einer Batterie verwendet werden kann, wobei das Modell Lithium-Plating nicht simuliert.
Fig. 9 zeigt einen Ersatzschaltkreis einer Batterie, der zum Modellieren einer Batterie verwendet werden kann, wobei das Modell Lithium-Plating simuliert.
Fig. 10, Fig. 11 und Fig. 12 zeigen Beispiele verschiedener Spannungs-Ladungs-Kurven.
Fig. 13 zeigt mögliche Verfahrensschritte beim Verfahren der Fig. 1.

### DETAILLIERTE BESCHREIBUNG VON AUSFÜHRUNGSBEISPIELEN

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Nachfolgend wird die vorliegende Erfindung anhand bevorzugter Ausführungsbeispiele unter Bezugnahme auf die Zeichnungen näher erläutert. In den Figuren bezeichnen gleiche Bezugszeichen gleiche oder ähnliche Elemente. Die Figuren sind schematische Repräsentationen verschiedener Ausführungsbeispiele der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und genereller Zweck dem Fachmann verständlich wird. In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein. Funktionale Einheiten können als Hardware, Software oder eine Kombination aus Hardware und Software implementiert werden.

Nachfolgend werden Techniken im Zusammenhang mit der Charakterisierung von wiederaufladbaren Batterien beschrieben. Die hierin beschriebenen Techniken können im Zusammenhang mit unterschiedlichsten Typen von wiederaufladbaren Batterien eingesetzt werden, bei denen Lithium-Plating auftreten kann, beispielsweise im Zusammenhang mit Batterien auf Lithium-Ionen-Basis, wie z.B. Lithium-Nickel-Mangan-Cobaltoxid-Batterien oder Lithium-Manganoxid-Batterien.

Die hierin beschriebenen wieder aufladbaren Batterien können in unterschiedlichen Anwendungsgebieten eingesetzt werden. Beispielsweise können die Batterien in Vorrichtungen wie Kraftfahrzeugen oder Drohnen oder tragbaren elektronischen Geräten wie etwa Mobilfunkgeräten verwendet werden. Es ist auch denkbar, die hierin beschriebenen Batterien in Form von stationären Energiespeichern einzusetzen. Die hier beschriebenen Verfahren können serverseitig durchgeführt werden. Die Verfahren können aber auch alternativ oder ergänzend, beispielsweise teilweise, von der Vorrichtung selbst durchgeführt werden, beispielsweise von einem Batteriemanagementsystem einer Vorrichtung. Hierbei können alle Schritte von der Vorrichtung durchgeführt werden. Alternativ können Teile von Schritten oder ganze Schritte von einer entfernten zusätzlichen Vorrichtung, beispielsweise einem Server, durchgeführt werden.

Der ermittelte Lithium-Plating-Zustand kann auf verschiedene Arten und Weisen eingesetzt werden. Zum Beispiel kann ein Ergebnis des Lithium-Plating-Zustands dazu verwendet werden, um den Betrieb der Batterie anzupassen. Derart könnte zum Beispiel eine übermäßige Alterung der Batterie vermieden werden. Alternativ oder zusätzlich könnte auch eine Zweitverwendung der Batterie auf Grundlage des Ergebnisses des Lithium-Plating-Zustands ermittelt werden. Zum Beispiel könnte bestimmt werden, ob die Batterie für einen bestimmten Einsatz noch geeignet ist oder aber aus dem Verkehr gezogen werden müsste. Eine weitere Möglichkeit des Einsatzes betrifft die gezielte Wartung und/oder Instandsetzung von Batterien in Abhängigkeit von dem Lithium-Plating-Zustand. Zum Beispiel wäre es möglich, solche Batterien zu warten oder auszutauschen etc., für welche ein verschlechterter Lithium-Plating-Zustand vorhergesagt wird.

Als allgemeine Regel können die hierin beschriebenen Techniken zur Bestimmung des Lithium-Plating-Zustands auf verschiedenen Ebenen eingesetzt werden: in einer einfachen Implementierung kann die Bestimmung des Lithium-Plating-Zustands auf Batterie-Ebene erfolgen, das heißt, es kann eine Bestimmung quer über alle Batterieblöcke und Zellen der Batterie erfolgen. In weiteren Beispielen wäre es aber auch möglich, dass das Bestimmen aufgelöst für verschiedene Batterieblöcke oder sogar Zellen individueller Batterieblöcke erfolgt, beispielsweise für Reihengeschaltete und/oder Parallelgeschaltete Batterieblöcke. Manchmal kann es möglich sein, dass eine Batterie zerlegt wird und einzelne Batterieblöcke entsorgt werden, wobei andere Batterieblöcke weiterverwendet werden. In einem solchen Beispiel kann eine individuelle Bestimmung, auch im Vorfeld, auf Batterieblock-Ebene erstrebenswert sein. Auch dies kann mit den hier beschriebenen Verfahren und Vorrichtungen möglich sein.

Verschiedene der hierin beschriebenen Beispiele können zumindest teilweise serverseitig implementiert werden. Dies bedeutet, dass zumindest ein Teil der mit den hier beschriebenen Verfahren und Vorrichtungen assoziierten Logik auf einem zentralen Server oder mehreren verteilten Servern (im Folgenden ebenfalls als ein Server bezeichnet), getrennt von der Batterie bzw. dem Batterie-betriebenen Gerät durchgeführt werden kann. Mit anderen Worten kann der Server ein einzelnes Computersystem sein. Der Server kann auch verteilt auf verschiedene Computersysteme ausgeführt sein, beispielsweise als sogenanntes Cloud Computing.

Dazu kann insbesondere eine Kommunikationsverbindung zwischen dem Server und einem oder mehreren Batterie-Management-Systemen der Batterie hergestellt werden. Durch die Implementierung zumindest eines Teils der Logik auf dem Server können besonders genaue und rechenintensive Modelle und/oder Simulationen im Zusammenhang mit der Lithium-Plating-Zustandsbestimmung eingesetzt werden. Dies ermöglicht es, die Zustandsbestimmung besonders genau durchzuführen. Zudem kann es möglich sein, Daten für ein Ensemble von Batterien zu sammeln und zu verwerten, zum Beispiel im Zusammenhang mit maschinengelernten Modellen.

Verschiedene hierin beschriebene Beispiele können die Zustandsbestimmung während des Einsatzes der Batterie auf Grundlage von Messdaten von der Batterie durchführen. Dies bedeutet, dass insbesondere zu einem bestimmten Zeitpunkt während des Lebens der Batterie der Lithium-Plating Zustand der Batterie bestimmt werden kann. Die Batterie kann sich dabei auch im Feldeinsatz befinden. Derart kann es insbesondere möglich sein, auch das bisherige Lithium-Plating Verhalten der Batterie zu berücksichtigen.

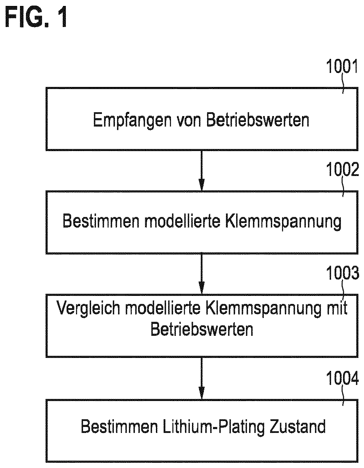

Fig. 1 zeigt ein Verfahren gemäß verschiedener Ausführungsbeispiele.

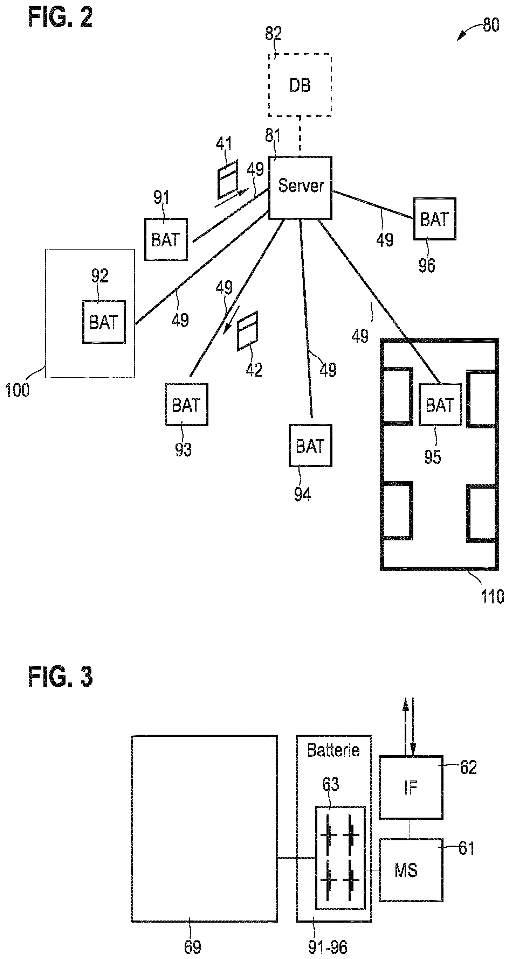

Das Verfahren kann zur Charakterisierung, beispielsweise einer serverseitigen Charakterisierung, einer wiederaufladbaren Batterie, die ein Risiko für Lithium-Plating aufweisen kann, eingesetzt werden. Das Verfahren der Fig. 1 kann beispielsweise durch das System 80 der Fig. 2 durchgeführt werden. Auf die Vorrichtungen der Fig. 2 wird nachfolgend Bezug genommen. In anderen Beispielen kann das Verfahren aber auch anders als mit dem System der Fig. 2 ausgeführt werden. Diese Beispiele sind daher nicht als einschränkend auszulegen.

Das Verfahren umfasst die folgenden Schritte:
Bei 1001 werden Betriebswerte 41 der Batterie, Beispielsweise eine der Batterien 91-96, als Zeitreihen empfangen. Hierbei können die Betriebswerte der Batterie beispielsweise eine Klemmenspannung der Batterie und/oder einen Batteriestrom der Batterie umfassen.

Die Klemmenspannung und der Batteriestrom können während eines Entladungsvorgangs und/oder eines Ladungsvorgangs der Batterie ermittelt werden. Die Klemmenspannung und der Batteriestrom können auch über kombinierte Ladungs- und Entladungsvorgänge hinweg ermittelt werden, beispielsweise über einen Ladungs- und einen Entladungsvorgang. Die jeweiligen Vorgänge können auch nur teilweise durchgeführt werden, beispielsweise ein Teilladungsvorgang sein.

Ein Ladungsvorgang kann dabei beispielsweise Laden der Batterie an einer externen Stromquelle sein, ein (Teil-)Ladungsvorgang kann aber auch durch andere Prozesse der Energiezuführung, beispielsweise Rekuperation bei einem Fahrzeug 110 der Fig. 2, sein.

Hierbei kann das Ermitteln während eines Einsatzes der Batterie stattfinden, also beispielsweise, während sich ein Fahrzeug mit der Batterie im Einsatz (manchmal auch als "Feldeinsatz" bezeichnet) befindet.

Bei 1002 erfolgt ein Bestimmen einer modellierten Klemmenspannung USim(t) mit einem Modell der Batterie.

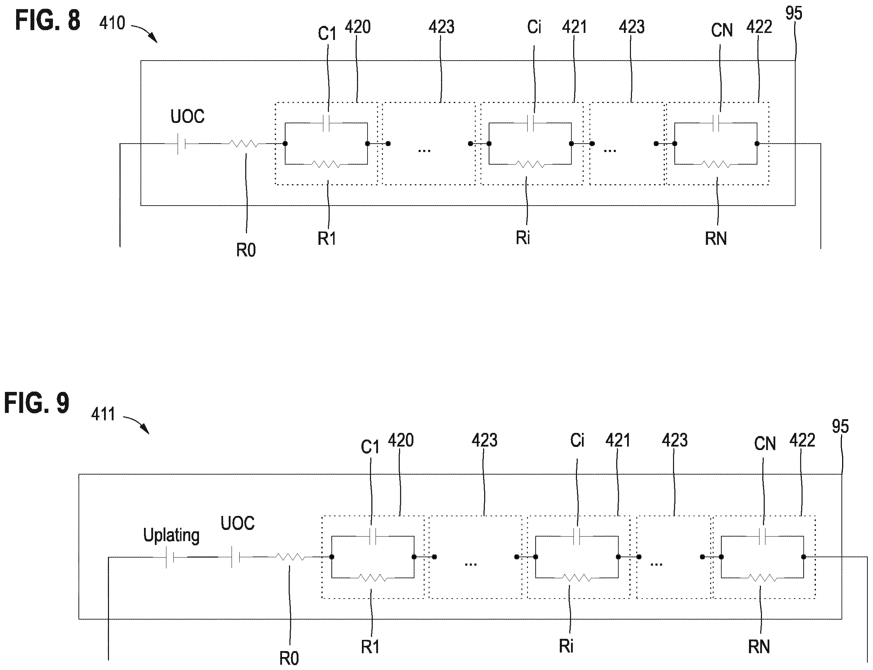

Bei dem Modell der Batterie kann es sich beispielsweise um eines der nachfolgend im Zusammenhang mit Fig. 8 und Fig. 9 beschriebenen Modellen handeln. Das Bestimmen der modellierten Klemmenspannung kann hierbei basierend auf dem Batteriestrom I(t) erfolgen.

Bei 1003 erfolgt ein Vergleichen der modellierten Klemmenspannung USim(t) mit der Klemmenspannung U(t).

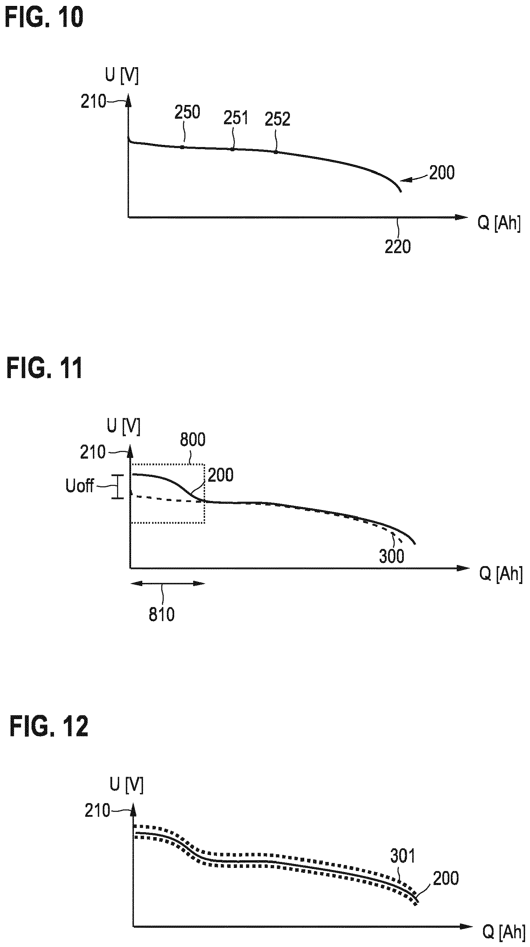

Das Vergleichen kann ferner umfassen: Bestimmen einer Spannungs-Ladungs-Kurve basierend auf der Klemmenspannung U(t) und dem Batteriestrom I(t).
Beispiele für Spannungs-Ladungs-Kurven 200 werden in den Fig. 10 bis Fig. 12 gezeigt und im Folgenden näher erläutert.

Eine Spannungs-Ladungs-Kurve 200 kann verwendet werden, um modellierte Klemmenspannungen mit ausgewählten Bereichen der Spannungs-Ladungs-Kurve 200 zu vergleichen. Eine Spannungs-Ladungs-Kurve kann ein Beispiel für die zuvor genannten aggregierten Daten sein. Insbesondere kann eine gegebene Spannungs-Ladungs-Kurve keine Zeitabhängigkeit aufweisen. Beispielsweise kann eine modellierte Klemmenspannung für einen vorgegebenen Ladungszustand, beispielweise 90%, bestimmt werden. Dies kann dann direkt mit dem entsprechenden Wert der ermittelten Spannungs-Ladungs-Kurve 200 verglichen werden. Mit anderen Worten kann die Modellierung der der Spannungs-Ladungs-Kurve 200 in manchen Beispielen nur für einen einzigen Punkt erfolgen. In anderen Beispielen können auch mehrere Punkte der Spannungs-Ladungs-Kurve bestimmt und/oder modelliert werden.

Das Vergleichen kann ferner umfassen: Bestimmen einer modellierten Spannungs-Ladungs-Kurve 300 basierend auf der modellierten Klemmenspannung ( USim(t) ) und dem Batteriestrom.

Das Verfahren kann ferner umfassen: Vergleichen der Spannungs-Ladungs-Kurve 200 mit der modellierten Spannungs-Ladungs-Kurve 300.

Solche Varianten des Vergleichens können den Vorteil haben, dass für das Vergleichen von bestimmten und modellierten Spannungs-Ladungs-Kurven auf Techniken zur Charakterisierung von Lithium-Plating zurückgegriffen werden kann, die das Vorhandensein von Spannungs-Ladungs-Kurven, z.B. aus Labormessungen, voraussetzt.

Alternativ kann bei 1003 anstelle des Vergleichens der Spannungs-Ladungs-Kurve 200 mit der modellierten Spannungs-Ladungs-Kurve 300, auch die Differenz zwischen beiden Kurven berechnet werden. Die Integration der Differenz beider Kurven ergibt eine charakteristische Fläche. Diese Fläche kann dann wiederum mit einer Referenzfläche verglichen werden, um bei 1004 ein Bestimmen eines Lithium-Plating-Zustands zu erreichen. Durch einen solchen Vergleich, der integrierte Spannungswerte berücksichtigt, kann eine besonders hohe Genauigkeit - die z.B. kurze zeitliche Fluktuationen kompensiert - erzielt werden.
Auch andere Varianten des Vergleichens von aggregierten Daten können durchgeführt werden. Beispielsweise können auch Histogramme, beispielsweise von Lade- und Entladezustände bestimmt werden und mit simulierten Histogrammen verglichen werden. Solche Vorgehensweise können den Vorteil haben, dass die Menge der zu erfassenden Daten, beispielsweise durch die Vorrichtung 100, reduziert werden kann und/oder die Menge an zu übertragenden Daten verringert werden kann. Hierdurch kann beispielsweise die Datenmenge, die über die Kommunikationsverbindungen 49 übertragen werden muss, verringert werden. Entsprechendes gilt auch für die Daten von Simulationen, deren Ergebnisse mit einer geringeren Datenmenge abgelegt, prozessiert und übermittelt werden kann.

Das Vergleichen der modellierten Klemmenspannung mit der Klemmenspannung kann auf einem Spannungsoffset zwischen der modellierten Klemmenspannung und der Klemmenspannung basieren. Dies wird nachfolgend im Zusammenhang mit Fig. 11 beschrieben.

Zusätzlich oder alternativ kann die modellierte Klemmenspannung auf einem Spannungsoffset basieren. Dies wird nachfolgend im Zusammenhang mit Fig. 12 beschrieben.

Bei 1004 erfolgt ein Bestimmen eines Lithium-Plating-Zustands der Batterie basierend auf dem Vergleichen bei 1003.

Das Bestimmen des Lithium-Plating-Zustands kann basierend auf einer Breite 810 eines Plateaus 800 der Spannungs-Ladungs-Kurve quantifiziert werden, wobei das Plateau 800 basierend auf dem Spannungsoffset Uoff bestimmt wird. Dies ist beispielhaft in den Fig. 11 und Fig. 12 gezeigt.

Fig. 2 zeigt ein System gemäß verschiedener Ausführungsbeispiele.

In dem Ausführungsbeispiel der Fig. 2 ist ein System 80 gezeigt.

In einem Beispiel kann das System 80 kann mindestens ein Fahrzeug, beispielsweise das Fahrzeug 110, mit einer Batterie, beispielsweise der Batterie 95 umfassen. Aber auch andere Vorrichtungen, beispielsweise die Vorrichtung 100 der Fig. 2 kann eine alternative oder zusätzliche Systemkomponente sein. Das Fahrzeug 110 kann eingerichtet sein, Betriebswerte an den Server 81 zu übertragen. Die Betriebswerte können hierbei umfassen: eine Klemmenspannung der Batterie als Zeitreihe und/oder einen Batteriestrom der Batterie als Zeitreihe. Der Server 81 kann eingerichtet sein, die Betriebswerte des mindestens einen Fahrzeuges 110, beispielsweise über Kommunikationsverbindungen 49, zu empfangen und damit mindestens eines der hier beschriebenen Verfahren auszuführen.

In einem weiteren Beispiel, welches mit dem vorherigen Beispiel kombiniert werden kann, aber auch unabhängig davon implementiert sein kann, ist der Server 81 eingerichtet, Betriebswerte 41 über jeweilige Kommunikationsverbindungen 49 zu empfangen. Die Betriebswerte 41 können hierbei insbesondere die Betriebswerte, die im Ausführungsbeispiel der hier beschriebenen Verfahren, beispielsweise dem Verfahren der Fig. 1, verwendet werden, sein.

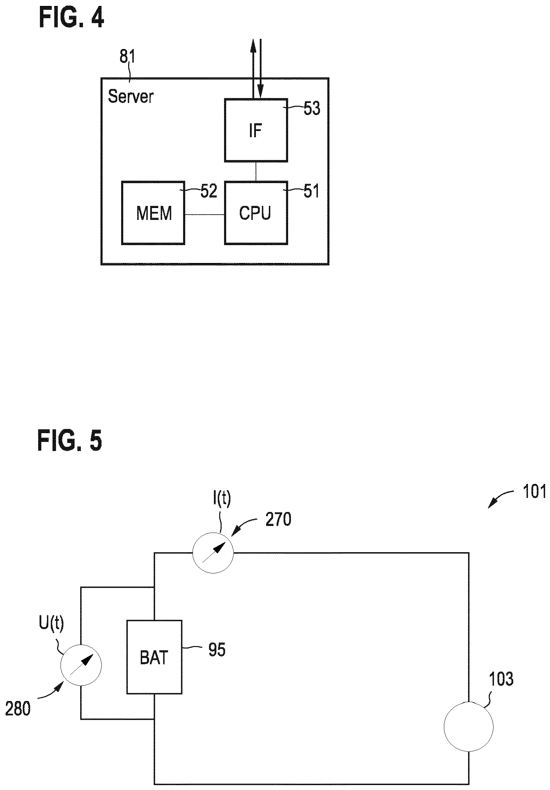

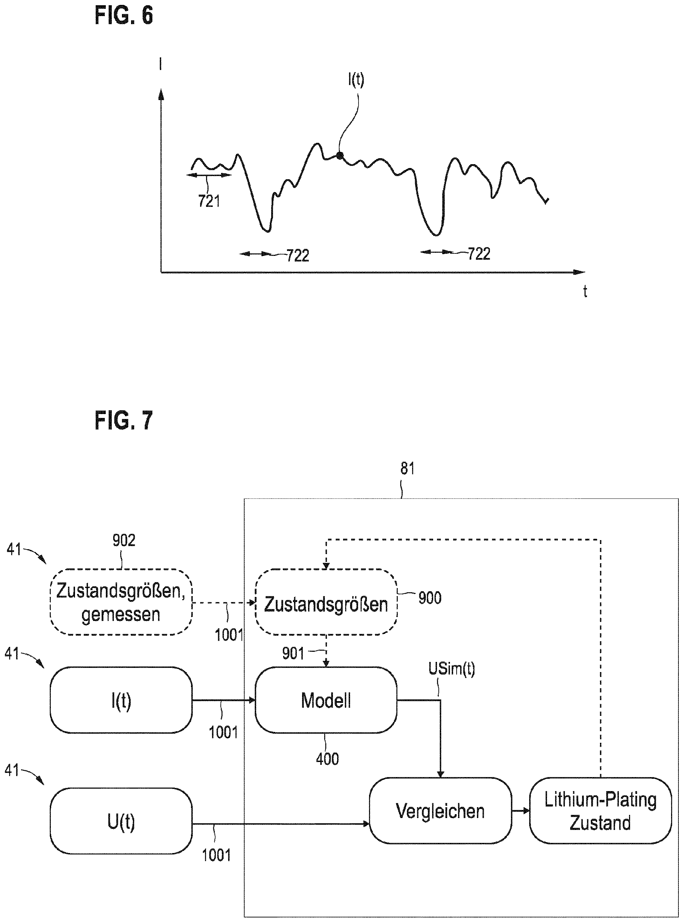

Der Server 81 kann beispielsweise der Server 81 der Fig. 4 und/oder der Fig. 7 sein.

Die Betriebswerte 41 können von verschiedenen Batterien 91 bis 96 bereitgestellt werden. Die Batterien können hierbei in verschiedenen Vorrichtungen eingebaut sein. Beispielsweise ist die Batterie 92 in einer Vorrichtung 100 eingebaut. Batterie 95 ist in einem Fahrzeug 110 eingebaut.

In Fig. 2 ist auch beispielhaft illustriert, dass der Server 81 über die Kommunikationsverbindungen 49 Steuerdaten 42 an die Batterien 91 bis 96 senden kann. Beispielsweise wäre es möglich, dass die Steuerdaten 42 ein oder mehrere Betriebsgrenzen für den zukünftigen Betrieb der jeweiligen Batterie 91 bis 96 indizieren. Zum Beispiel könnten die Steuerdaten ein oder mehrere Steuerparameter für ein Thermomanagement der jeweiligen Batterie 91 bis 96 und/oder ein Lademanagement der jeweiligen Batterie 91 bis 96 indizieren. Durch Verwendung der Steuerdaten 42 kann der Server 81 also in manchen Ausführungsbeispielen den Betrieb der Batterien 91 bis 96 beeinflussen bzw. steuern. Hierbei kann dem Verfahren der Fig. 1 bestimmte Zustand des Lithium-Platings beispielsweise verwendet werden, um Steuerdaten 42 für die jeweilige Batterie zu bestimmen. Hierdurch kann beispielsweise ein Fortschreiten des Lithium-Platings verringert oder sogar vermieden werden, beispielsweise indem zulässige Ladehöchstströme, beispielsweise als Funktion einer Temperatur der Batterie, definiert werden.

Fig. 3 zeigt ein Beispiel einer Batterie, die eine Vorrichtung versorgt.

In Fig. 3 werden weitere mögliche Komponenten der schematisch in Fig. 2 gezeigten Batterien 92 bis 96 gezeigt. Bei der gezeigten Batterie 91 bis 96 kann es sich beispielsweise um die Batterie 92 der Fig. 2 handeln. Die Batterie 91 bis 96 kann hierbei eine Vorrichtung 69 mit elektrischer Energie versorgen. Die in Fig. gezeigte Vorrichtung 69 kann beispielsweise die Vorrichtung 100 der Fig. 2 oder das Fahrzeug 110 der Fig. 2 sein.

Die Batterie 91-96 kann mehrere Batterieblöcke 63 umfassen. Jeder Batterieblock 63 umfasst typischerweise eine Anzahl von parallelgeschalteten und/oder seriell geschalteten Batteriezellen. Dort kann elektrische Energie gespeichert werden. Das Verhalten der Batterie 91-96 wird durch ein Batterie-Management-System 61 oder durch mehrere Batterie-Management-Systeme gesteuert. Das Batterie-Management-System 61 kann beispielsweise ein sogenanntes BMS oder eine andere Steuerlogik wie eine On-Board-Unit im Falle eines Fahrzeugs sein. Das Batterie-Management-System 61 kann zum Beispiel durch Software auf einem Prozessor implementiert sein. Alternativ oder zusätzlich könnte zum Beispiel ein applikationsspezifischer Schaltkreis (ASIC) oder ein feldprogrammierbares gated array (FPGA) verwendet werden. Auch eine Ausführung des Batterie-Management-Systems 61 zumindest teilweise in einer Cloud ist möglich.

Die Batterien 91-96 können beispielsweise mittels einem Bussystem mit dem Batterie-Management-System 61 kommunizieren. Die Batterien 91-96 können auch eine Kommunikationsschnittstelle 62 umfassen. Das Batterie-Management-System 61 kann über die Kommunikationsschnittstelle 62 eine Kommunikationsverbindungen 49 mit dem Server 81 aufbauen. Die Kommunikationsschnittstelle 62 kann eingerichtet sein, Betriebswerte 41 an den Server 81 zu übermitteln. Die Kommunikationsschnittstelle 62 kann ferner eingerichtet sein, Steuerdaten, beispielsweise die Steuerdaten 42 der Fig. 2, zu empfangen. In solchen Beispielen kann das Batterie-Management-System 61 eingerichtet sein, ein Steuer- und/oder Regelungsverhalten basierend auf den Steuerdaten 42 anzupassen.

Während in Fig. 3 das Batterie-Management-System 61 separat von den Batterien 91 bis 96 gezeichnet ist, ist es in anderen Beispielen auch möglich, dass das Batterie-Management-System 61 Teil der Batterien 91 bis 96 ist. Entsprechendes gilt für die Kommunikationsschnittstelle 62.

Typischerweise kann das Batterie-Management-System 61 auf ein oder mehrere Sensoren in den ein oder mehreren Batterieblöcken 63 zurückgreifen. In manchen Beispielen kann das Batterie-Management-System 61 ergänzend oder alternativ auf weitere Sensordaten zugreifen. Die Sensoren können zum Beispiel den Stromfluss und/oder die Spannung in zumindest einigen der Batteriezellen messen. Die Spannung kann hierbei sowohl im Leerlaufbetrieb, manchmal auch als open circuit voltage (OCV) bezeichnet, oder aber im Lastbetrieb, manchmal als Klemmenspannung bezeichnet, bestimmt werden. Die Sensoren können alternativ oder zusätzlich auch andere Größen im Zusammenhang mit zumindest einigen der Batteriezellen messen, beispielsweise Temperatur, Volumen, Druck, etc. Das Batterie-Management-System 61 kann eingerichtet sein, um auf Grundlage von einem oder mehreren solcher Messwerte von Sensoren aktuelle Zustandsgrößen für die jeweilige Batterie 91 bis 96 bzw. optional auch für individuelle Batterieblöcke zu bestimmen. In solchen Fällen, in denen weitere Daten vorliegen, können diese ebenfalls über die Kommunikationsschnittstelle 62 an den Server 81 der Fig. 2 übermittelt werden. Dies kann es beispielsweise ermöglichen, das Verfahren der Fig. 1 auch auf anderen Ebenen, beispielsweise auf der Ebene für einzelne parallelgeschaltete Zellen, durchzuführen, beispielsweise, wenn die Klemmenspannung für die parallelgeschalteten Zellen gemeinsam ermittelt wird. Hierdurch kann es beispielsweise möglich sein, einen Lithium-Plating-Zustand nicht nur für die gesamte Batterie 91 bis 96, sondern für Unterebenen der Batterie 91 bis 96 zu bestimmen.

Fig. 4 zeigt ein Beispiel eines Servers.

Der in Fig. 4 beispielhaft gezeigte Server 81 umfasst einen Prozessor 51 sowie einen Speicher 52. Der Speicher 52 kann ein flüchtiges Speicherelement und/oder ein nichtflüchtiges Speicherelement umfassen. Außerdem umfasst der Server 81 auch eine Kommunikationsschnittstelle 53. Der Prozessor 51 kann über die Kommunikationsschnittstelle 53 eine Kommunikationsverbindung 49 mit jeder der Batterien 91 bis 96 und optional mit der Datenbank 82 aufbauen.

Zum Beispiel kann Programmcode im Speicher 52 gespeichert sein und vom Prozessor 51 geladen werden. Der Prozessor 51 kann dann den Programmcode ausführen. Das Ausführen des Programmcodes kann bewirken, dass der Prozessor 51 ein oder mehrere der Verfahren ausführt, wie sie im Zusammenhang mit den verschiedenen Beispielen hierin im Detail beschrieben sind.

Erfindungsgemäß kann ein Computerprogramm mit einem Programmcode bereitgestellt werden. Dieser kann, wenn er auf einem Prozessor, beispielsweise dem Prozessor 51, ausgeführt wird, bewirken, dass eines der hier beschriebenen Verfahren durchgeführt wird.

Wie zuvor erwähnt kann der Server 81 auch eine logische Einheit sein und beispielsweise als ein virtueller Server oder ein Cloud-Server realisiert sein.

Fig. 5 zeigt ein Beispiel einer elektrischen Schaltung umfassend eine wiederaufladbare Batterie.

In Fig. 5 ist ein schematischer Ersatzschaltkreis für eine Schaltung 101, umfassend eine Batterie 95, gezeigt. Die Schaltung 101 kann beispielsweise in dem Fahrzeug 110 der Fig. 2 oder in einer anderen Vorrichtung, beispielsweise der Vorrichtung 100 der Fig. 2 eingebaut sein.

Im gezeigten Beispiel werden Betriebswerte 41 der gezeigten Batterie 95 als Zeitreihen wie nachfolgend beschrieben bestimmt. In anderen Beispielen können andere Betriebswerte und/oder alternative Betriebswerte erfasst werden. Die Batterie 95 kann beispielsweise die Batterie 95 der Fig. 1 sein, die in einem Fahrzeug 110 verbaut sein kann. Es kann sich aber auch um eine andere Batterie handeln. Im schematisch gezeigten Beispiel ist die Batterie 95 mit einem Verbraucher 103 gekoppelt. Bei dem Verbraucher 103 kann es sich beispielsweise um den Antriebsstrang eines elektrischen Fahrzeugs handeln. Nicht gezeigt in der schematischen Darstellung 101 ist eine Steuerung, welche das Lastverhalten des Verbrauchers 103 regelt. Dies kann Bestandteil des Verbrauchers 103 selbst sein.

In Reaktion auf das Lastverhalten des Verbrauchers 103 stellt die Batterie 95 einen Strom I(t) bereit. Dieser Strom kann von einem Strommessgerät 270 gemessen werden. Ebenfalls abhängig von dem Lastverhalten des Verbrauchers 103 und der Charakteristik der Batterie 95, beispielsweise dem Ladungszustand und/oder anderen Zustandsgrößen der Batterie 95, liegt an der Batterie 95 eine Klemmenspannung U(t) an. Diese Klemmenspannung U(t) kann von einem zweiten Messgerät 280 erfasst werden.

Die Klemmenspannung U(t) und der Batteriestrom I(t) können von den Messgeräten 270, 280 als Funktion der Zeit für mindestens zwei verschiedene Zeitpunkte gemessen werden. Hierdurch können Zeitreihen dieser Betriebswerte erfasst werden. Dies kann beispielsweise durch das Batterie-Management-System 61 der Fig. 3 erfolgen, aber auch andere Implementierungen sind möglich. Die so erfassten Zeitreihen der Betriebswerte können dann, beispielsweise mit den Kommunikationsverbindungen 49 der Fig. 2 zu dem Server 81 der Fig. 2 übermittelt werden. In anderen Ausführungsbeispielen ist es auch möglich, dass die Betriebswerte zunächst lokal gespeichert werden und beispielsweise bei Wartungsarbeiten, beispielsweise in einer Werkstatt, die Kommunikationsverbindungen 49 der Fig. 2 aufgebaut wird, beispielsweise, wenn eine Verbindung zu einem Diagnoseport des Fahrzeugs 110 oder der Vorrichtung 100 der Fig. 2 aufgebaut wird. In solchen Fällen können die Zeitreihen beispielsweise vom Batterie-Management-System 61 gespeichert werden, aber auch andere Möglichkeiten existieren.

Fig. 6 zeigt ein Beispiel einer Zeitreihe des Batteriestroms der Batterie.

Fig. 6 zeigt einen Batteriestrom I(t), der von einer Batterie, beispielsweise der Batterie 95 der Fig. 5 in Reaktion auf ein Lastprofil eines Verbrauchers, beispielsweise den Verbraucher 103 der Fig. 5, fließt. Im gezeigten Beispiel der Fig. 6 ist der Batteriestrom I(t) positiv. Es wechseln sich Phasen verhältnismäßig konstanter Stromanforderungsprofile 721 mit Phasen zeitlich stark veränderlicher Stromanforderungsprofile 722 ab. Ein positiver Strom kann bedeuten, dass die Batterie entladen wird. In anderen Beispielen, kann der Batteriestrom I(t) auch erfasst werden, während die Batterie geladen wird, beispielsweise während eines Aufladungsvorgangs, oder während andere Prozesse, beispielsweise Rekuperation während dem Betrieb eines Fahrzeugs. In solchen Fällen wäre die Kurve I(t) in der Konvention der Fig. 6 negativ. Aus der Zeitreihe des Batteriestrom I(t) kann beispielsweise die geflossene Ladung durch zeitliche Integration ermittelt werden. Die geflossene Ladung kann dann verwendet werden, um Spannungs-Ladungs-Kurve zu bestimmen. Dies wird nachfolgend in Zusammenhang mit den Figuren Fig. 10 - Fig.12 beschrieben.

Zunächst wird jedoch anhand der Fig. 7 ein mögliches weiteres Vorgehen mit den so bestimmten Betriebswerten der Batterie als Zeitreihen beschrieben.

Fig. 7 zeigt eine mögliche Implementierung des Verfahrens der Fig. 1.

Fig. 7 zeigt mögliche Abläufe, die innerhalb des Servers 81 durchgeführt werden können, um das Verfahren der Fig. 1 zu verwirklichen. Der Server 81 kann beispielsweise der Server 81 der Fig. 4 sein.

Zur Durchführung eines der hier beschriebenen Verfahren empfängt 1001 der Server 81 Betriebswerte 41 einer Batterie. Die Batterie kann beispielsweise die Batterie 95 der Fig. 5 und/oder der Fig. 6 sein. Als Betriebswerte 41 können beispielsweise die Klemmenspannung der Batterie als Zeitreihe U(t) und ein Batteriestrom der Batterie als Zeitreihe I(t) bereitgestellt werden.

Der Server 81 bestimmt mittels eines Modells 400 eine modellierte Klemmenspannung USim(t) basierend auf dem Batteriestrom I(t). In einem weiteren Schritt erfolgt ein Vergleichen 1003 der modellierten Klemmenspannung USim(t) mit der Klemmenspannung U(t). Basierend auf dem Vergleichen 1003 erfolgt ein Bestimmen 1004 des Lithium-Plating-Zustands der Batterie. Der Lithium-Plating-Zustand der Batterie bei 1004 kann vom Server 81 gespeichert und/oder an andere Anwendungen bereitgestellt werden, beispielsweise in der Datenbank 82 der Fig. 1 abgelegt werden, oder in weiteren Prozessen dazu verwendet werden, Steuerdaten 42 für die jeweilige Batterie bereitzustellen.

In manchen Ausführungsbeispielen kann basierend auf dem für eine erste Batterie bestimmten Lithium-Plating-Zustands auch Steuerdaten 42 für eine zweite Batterie bereitgestellt werden. Tritt beispielsweise bei der ersten Batterie bei einer schnellen Ladung bei einer niedrigen Batterietemperatur Lithium-Plating auf, kann für ähnliche oder baugleiche andere Batterien, beispielsweise eine zweite Batterie, die beispielsweise in einem vergleichbaren Serienfahrzeug wie die erste Batterie verbaut sein kann, Steuerdaten 42 bereitgestellt werden, die ein Lithium-Plating dieser anderen Batterien verhindern.

In manchen Ausführungsbeispielen kann der Lithium-Plating-Zustand 1004 auch verwendet werden, um Zustandsgrößen 900 zu ermitteln. Die Zustandsgrößen 900 können, wie bei 901 angedeutet, im Modell 400 berücksichtigt werden.

In manchen Ausführungsbeispielen kann zusätzlich eine oder mehrere Zustandsgrößen 900 der Batterie an den Server 81 bereitgestellt werden. Die Zustandsgröße 900 kann hierbei beispielsweise die Temperatur der Umgebung der Batterie, eine Temperatur der Batterie, ein Ladungszustand, manchmal auch als State of Charge, SOC, bezeichnet, ein Alterungszustand der Batterie, eine Ereignishistorie der Batterie und/oder eine Stromrate einer Belastung der Batterie sein. Aber auch andere Zustandsgrößen 900 sind möglich. Hierbei kann die Stromrate der Belastung der Batterie der von der Batterie abgerufene Strom der Batterie sein. Der Strom kann mit einer Nennkapazität der Batterie normiert sein.

Die Zustandsgrößen 900 können von weiteren Modellen bereitgestellt werden, beispielsweise basierend auf den Zeitreihen der Klemmenspannung U(t) und/oder den Zeitreihen des Batteriestroms I(t) ermittelt werden. Alternativ oder ergänzend können die Zustandsgrößen auch basierend auf gemessenen Zustandsgrößen 902 bestimmt werden. Beispielsweise kann eine Temperatur 902 direkt in einer Batteriezelle gemessen werden und nach Übertragung an den Server 81 direkt als Zustandsgröße 900 verwendet werden. In anderen Beispielen kann beispielsweise basierend auf einer gemessenen Außentemperatur eines Fahrzeugs 902 und den Zeitreihen des Batteriestroms I(t) und/oder der Klemmenspannung U(t) eine lokale Temperatur der Batterie modelliert werden, beispielsweise mittels einer thermischen Simulation und basierend hierauf beispielsweise eine Temperatur einer Batteriezelle als Funktion der Zeit als eine Zustandsgröße 900 bereitgestellt werden.

Die Temperatur der Umgebung der Batterie kann beispielsweise auch anhand von Wetterdaten, beispielsweise auf Grundlage von Positionsmessungen der Batterie, beispielsweise aufgrund von GPS-Messungen eines Fahrzeugs mit einer Batterie ermittelt werden. Solche Zustandsgrößen 902 können also auch vom Server 81 selbst bestimmt werden, beispielsweise durch Abrufe von Wettermodellen für GPS Koordinaten. Die Temperatur der Batterie kann beispielsweise durch Messungen, beispielsweise durch Messungen mit einem Temperatursensor durch das Batterie-Management-System, erfasst werden.

Das Modell 400 kann von mindestens einer Zustandsgröße 900 abhängig sein. Beispielsweise kann mindestens ein Element, beispielsweise ein Bauelement, des Modells der Batterie, wie beispielsweise in den Fig. 8 und Fig. 9 gezeigt, beispielsweise die Spannungsquelle UOC und/oder das RC-Glied 420 von mindestens einer Zustandsgröße abhängig sein.

Die Figuren 8 und 9 zeigen Beispiele für Batteriemodelle.

Fig. 8 zeigt einen Ersatzschaltkreis 410, der zum Modellieren einer Batterie 95 verwendet werden kann, wobei das Modell Lithium-Plating nicht simuliert.

Fig. 9 zeigt einen weiteren Ersatzschaltkreis 411 einer Batterie, der zum Modellieren einer Batterie 95 verwendet werden kann, wobei das Modell Lithium-Plating simuliert.

Die Ersatzschaltkreise 410, 411 können verwendet werden, um das Modell 400 der Fig. 7 bereitzustellen.

Die Ersatzschaltkreise 410, 411 umfassen jeweils eine Spannungsquelle UOC und einen Widerstand R0. In den gezeigten Beispielen der Ersatzschaltkreise 410, 411 ist zusätzlich jeweils mindestens ein RC-Glied vorhanden, beispielsweise eine Vielzahl von RC-Gliedern 420 bis 423. Das mindestens eine RC-Glied kann beispielsweise ein erstes RC-Glied und ein zweites RC-Glied umfassen, wobei der mindestens eine Widerstand und das erste RC-Glied und das zweite RC-Glied miteinander jeweils in Reihe geschaltet sein können. Zusätzlich können das erste und das zweite RC-Glied mit der idealen Spannungsquelle in Reihe geschaltet sein. In manchen - in Fig. 8 und 9 nicht gezeigten - Ausführungsbeispielen ist hingegen kein RC-Glied vorhanden.

Im gezeigten Beispiel der Fig. 8 und der Fig. 9 umfasst jedes der RC-Glieder 420 bis 423 jeweils einen Widerstand und eine Kapazität, welche jeweils parallel miteinander verschaltet sind. So umfasst das RC-Glied 420 einen ersten Widerstand R1 und eine erste Kapazität C1. Das i-te RC-Glied 421 umfasst einen Widerstand Ri und eine Kapazität Ci und das N-te RC-Glied 422 umfasst einen Widerstand Rn und eine Kapazität Cn. Durch die Punkte zwischen den RC-Gliedern wird angedeutet, dass weitere RC-Glieder 423 optional vorhanden sein können.

Durch solche Ersatzschaltkreise wie die gezeigten Ersatzschaltkreise 410, 411 aber auch durch Ersatzschaltkreise die weniger als die in den Beispielen gezeigten Komponenten umfassen oder zusätzliche weitere Komponenten aufweisen ist es möglich, ein zeitdynamisches Lastverhalten der Batterie 95 zu simulieren.

Die Spannungsquelle UOC kann eine ideale Spannungsquelle sein. Diese kann beispielsweise als Funktion eines Ladungszustands der Batterie 95 parametrisiert sein. In anderen Beispielen kann die UOC weitere Eigenschaften aufweisen. Diese Eigenschaften können beispielsweise als Funktion von Zustandsgrößen, beispielsweise der Zustandsgrößen 900 der Fig. 7, parametrisiert sein. Beispielsweise kann eine Temperaturabhängigkeit der Spannungsquelle UOC parametrisiert sein.

Die gezeigten Ersatzschaltkreise 410, 411 können in manchen Beispielen weitere Elemente enthalten. Hierdurch können beispielsweise weitere Eigenschaften der Batterien simuliert werden. In anderen Beispielen enthalten die Ersatzschaltkreise 410, 411 keine weiteren Elemente oder, wie zuvor beschrieben, weniger Elemente. In einem Beispiel umfasst ein Ersatzschaltkreise einen Widerstand R0 und eine ideale Spannungsquelle UOC.

Durch Ersatzschaltkreise mit wenigen Elementen kann eine besonders effiziente Simulation erreicht werden, die mit weniger Aufwand gerechnet werden kann und gleichzeitig für manche Aufgaben genau genug sein kann.

In manchen Beispielen mit mindestens einem RC-Glied werden 10 RC-Glieder verwendet, in manchen Beispielen 8 RC-Glieder, in manchen Beispielen 6 RC-Glieder, in manchen Beispielen 4 RC-Glieder. Aber auch eine andere Anzahl an RC-Gliedern ist möglich.

Im Ersatzschaltkreis 411 der Fig. 9 ist eine weitere Spannungsquelle, UPlating, vorhanden. Auch der Ersatzschaltkreis 411 der Fig. 9 ist exemplarisch zu verstehen und kann, wie im Zusammenhang mit Fig. 8 erörtert, weniger oder mehr Komponenten umfassen als im gezeigten Beispiel.

Die weitere Spannungsquelle UPlating kann verwendet werden, um eine auftretende Spannungsänderung aufgrund von Lithium-Plating-Prozessen durch das Modell 411 abbilden zu können.

Die jeweiligen Bauteile der Ersatzschaltkreise 410, 411 können basierend auf der mindestens einen Zustandsgröße 900 der Batterie angepasst werden. Beispielsweise kann der i-te Widerstand Ri und die i-te Kapazität Ci in Reaktion auf eine Temperatur der Batterie variiert werden. Dies kann technisch beispielsweise mittels einer Look-up Tabelle realisiert werden. Aber auch andere Verfahren, beispielsweise funktionelle Beschreibungen der Dimensionierung beispielsweise der Kapazität Cn als Funktion einer Zustandsgröße, beispielsweise dem äußeren Luftdruck, können vorgenommen werden.

Die Ersatzschaltkreise, beispielsweise die in den Fig. 8 und Fig. 9 gezeigten Ersatzschaltkreise 410, 411 können zusätzlich oder alternativ ein Hysterese-Element umfassen. Das Hysterese-Element kann eingerichtet sein, ein Hystereseverhalten der Batterie zu modellieren.

Für sich genommen sind verschiedene Modelle zur Modellierung von Hystereseverhalten bekannt, beispielsweise das Zero-State und One-State Hysteresemodell, wie es beispielsweise in Plett, G. L.: Extended Kalman filtering for battery management systems of LiPB-based HEV battery packs, Journal of Power Sources 134 (2004), Nr. 2, S. 252- 261 beschrieben wird. Ebenfalls sind Modelle nach Verbrugge et al. bekannt, wie diese beispielsweise in Verbrugge, M., Tate, E.: Adaptive state of charge algorithm for nickel metal hydride batteries including hysteresis phenomena, Journal of Power Sources 126 (2004), 1-2, S. 236-249 und Verbrugge, M. :Adaptive, multi-parameter battery state estimator with optimized time-weighting factors, Journal of Applied Electrochemistry 37 (2007), Nr. 5, S. 605-616 beschrieben sind.

Solche Modelle können, beispielsweise implementiert in Form eines zusätzlichen Elements in dem Ersatzschaltkreis, verwendet werden, um das Modell der Batterie 400 so auszulegen, dass ein Hystereseverhalten der Batterie, beispielsweise beim Wechsel von einem Aufladevorgang zu einen Entladevorgang, modelliert wird.

Auch die Verwendung von diesen oder anderen Hysteresemodellen, auch in Kombination mit den hier beschriebenen Ersatzschaltkreisen, ist möglich.

Die Fig. 10, die Fig. 11 und die Fig. 12 zeigen Beispiele verschiedener Spannungs-Ladungs-Kurven.

In Fig. 10 ist eine beispielhafte Spannungs-Ladungs-Kurve 200 gezeigt. Im gewählten Koordinatensystem ist die Ladung in Ampere-Stunden als x-Achse 220, die Spannung in Volt als y-Achse 210 aufgetragen. Die gezeigte Spannungs-Ladungs-Kurve 200 kann basierend auf der Klemmenspannung U(t) und dem Batteriestrom I(t) ermittelt werden. Dies ist mit Punkten 250, 251, 252 angedeutet. Die Spannungs-Ladungs-Kurve 200 kann sich aus einer Vielzahl solcher Punkte zusammensetzen. Die y-Koordinate des Punktes 250 kann beispielsweise für einen gegebenen Zeitpunkt T aus der Klemmenspannung der Batterie als Zeitreihe (t) ermittelt werden, wobei y gleich U(t = T) gelten kann. Die x-Koordinate des Punktes 250 kann beispielsweise durch zeitliche Integration des Batteriestroms der Batterie als Zeitreihe I(t) ermittelt werden. Beispielsweise kann die geflossene Ladung durch zeitliche Integration der in Fig. 6 gezeigten Kurve für den vorgegebenen Zeitpunkt T bestimmt werden. Bezüglich der Integrationsgrenzen können hierbei Annahmen getroffen werden. Beispielsweise kann angenommen werden, dass zu einem Zeitpunkt t = T0 die Batterie vollständig geladen ist und die geflossene Ladung Q = 0 Ampere-Stunden gesetzt werden kann. In anderen Beispielen kann die Integrationskonstante basierend auf weiteren Modellen, beispielsweise für den Ladungszustand und/oder Alterungszustand, bestimmt werden. Auch ein zuvor, also beispielsweise in einem vorherigen Ladungs-/Entladungszyklus bestimmter Lithium-Plating-Zustand kann zur Bestimmung der Integrationskonstante herangezogen werden.

Die gezeigte Spannungs-Ladungs-Kurve 200 der Fig. 10 ist eine Beispiel-Spannungs-Ladungs-Kurve für eine Batterie, welche kein Lithium-Plating aufweist.

Fig. 11 zeigt eine Spannungs-Ladungs-Kurve 200 von einer Batterie mit Lithium-Plating. Dies ist insbesondere im Bereich 810 deutlich zu sehen, wo die Bildung eines Plateaus im Spannungs-Ladungs-Diagramm ersichtlich ist. Die Spannungs-Ladungs-Kurve 200 kann mit einer modellierten Spannungs-Ladungs-Kurve 300 verglichen werden. Im gezeigten Beispiel weist die Spannungs-Ladungs-Kurve 200 ein Spannungsoffset Uoff zu der modellierten Spannungs-Ladungs-Kurve 300 auf. Das Spannungsoffset Uoff kann hierbei indikativ für Lithium-Plating sein.

Das Bestimmen des Lithium-Plating-Zustands kann basierend auf der Breite 810 des Plateaus 800 der Spannungs-Ladungs-Kurve 200 quantifiziert werden. Das Plateau 800 kann zusätzlich oder alternativ basierend auf dem Spannungsoffset Uoff bestimmt werden.

Beispielsweise kann eine erwartete mathematische Funktion verwendet werden, um das Plateau 800 zu charakterisieren, beispielsweise mittels einer Funktion, die eine tanh-Funktion umfasst. Aber auch andere Funktionen sind möglich.

Der Spannungsoffset Uoff kann zwischen 50 mV und 150 mV, insbesondere zwischen 80 mV und 120 mV liegen.

Der Spannungsoffset kann das Ergebnis von elektrochemischen Spannungsreihen sein und sich beispielsweise durch die unterschiedlichen Oxidationspotentiale von metallischem und deinterkaliertem Material ergeben. Beispielsweise ist aus Ratnakumar V. Bugga and Marshall C. Smart, "Lithium Plating Behavior in Lithium-Ion Cells", ECS Trans. 2010 volume 25, issue 36, 241-252, doi: 10.1149/1.3393860 bekannt, dass Oxidationspotentiale für metallisches Lithium um ca. 100 mV höher als bei Deintercalation ist. Für solche Systeme kann ein Spannungsoffset Uoff von ca. 100 mV, beispielsweise 100 mV, gewählt werden. Bei anderen Systemen können entsprechende Zahlenwerte berechnet werden.

Der Spannungsoffset Uoff kann beispielsweise als ein Parameter der tanh-Funktion verwendet werden.

Die modellierte Spannungs-Ladungs-Kurve 300 kann basierend auf der modellierten Klemmenspannung USim(t) und dem Batteriestrom I(t) bestimmt sein. Das Vorhandensein von Lithium-Plating in der Batterie kann dann aus Vergleichen der Spannungs-Ladungs-Kurve 200 mit der modellierten Spannungs-Ladungs-Kurve 300 ermittelt werden. Die modellierte Spannungs-Ladungs-Kurve 300 kann beispielsweise mittels dem Ersatzschaltkreis 410 der Fig. 8 ermittelt werden. Da die modellierte Spannungs-Ladungs-Kurve 300 Lithium-Plating nicht berücksichtigt, kann aus der Diskrepanz zwischen der modellierten Spannungs-Ladungs-Kurve 300 und der gemessenen Spannungs-Ladungs-Kurve 200, beispielsweise im Bereich 800, geschlossen werden, dass bei der Batterie Lithium-Plating aufgetreten ist. In einem anderen Fall, beispielsweise bei Vorliegen der in Fig. 10 gezeigten Spannungs-Ladungs-Kurve 200, würde die modellierte Spannungs-Ladungs-Kurve 300 mit der gemessenen Spannungs-Ladungs-Kurve 200 der Fig. 10 im Rahmen der Fehler übereinstimmen. Basierend hierauf kann in einem solchen Fall bestimmt werden, dass kein Lithium-Plating vorliegt.

Fig. 12 zeigt die Spannungs-Ladungs-Kurve 200 der Fig. 11, jedoch eine andere modellierte Spannungs-Ladungs-Kurve 301. Die in Fig. 12 gezeigte modellierte Spannungs-Ladungs-Kurve 301 kann beispielsweise basierend auf einem Modell, welches den Ersatzschaltkreis 411 der Fig. 9 umfassen kann, bestimmt worden sein.

Da der Ersatzschaltkreis 411 eine Spannungsquelle UPlating aufweist, kann es möglich sein, dass die modellierte Spannungs-Ladungs-Kurve 301 auch in dem Bereich 800 mit dem Verlauf der bestimmten Spannungs-Ladungs-Kurve 200 übereinstimmt. In diesem Fall kann also dadurch, dass eine modellierte Spannungs-Ladungs-Kurve 301, die Lithium-Plating modelliert, mit der bestimmten Spannungs-Ladungs-Kurve 200 im Rahmen der Fehler übereinstimmt, darauf geschlossen werden, dass bei der Batterie Lithium-Plating vorhanden ist.

Verfahren zur Ermittlung der Spannungs-Ladungs-Kurve wie im Zusammenhang mit den Figuren 10 bis 12 beschrieben, können es ferner ermöglichen, das Lithium-Plating zu quantifizieren. Dies kann beispielsweise durch Angabe der Breite 810 der Fig. 11 quantitativ geschehen.

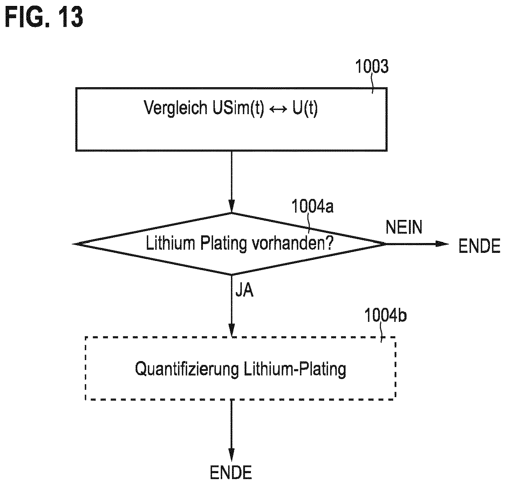

Fig. 13 zeigt mögliche Verfahrensschritte beim Verfahren der Fig. 1.

In der Variante der Fig. 13 findet bei 1003 ein Vergleich von USim(t) mit U(t) statt. Dies kann beispielsweise wie im Zusammenhang mit den Figuren 10 bis 12 beschrieben mittels Spannungs-Ladungs-Kurven vorgenommen werden. Aber auch andere Vorgehensweisen sind möglich.

Basierend aus dem Vergleichen 1003 erfolgt nun ein Bestimmen 1004a, ob Lithium-Plating bei der Batterie vorhanden ist. Ist dies nicht der Fall, endet der Algorithmus. Die Information, dass kein Lithium-Plating vorhanden ist, kann gespeichert und/oder weitergegeben werden.

Ist Lithium-Plating vorhanden, kann der Algorithmus ebenfalls beendet werden, wobei die Information, dass Lithium-Plating vorhanden ist, gespeichert und/oder weitergegeben werden kann. Zusätzlich kann bei 1004b eine Quantifizierung des Lithium-Platings, wie zuvor beschrieben, erfolgen. Die Quantifizierung des Lithium-Platings kann ebenfalls gespeichert und/oder weitergegeben werden. Danach endet der Algorithmus.

Selbstverständlich können die Merkmale der vorab beschriebenen Ausführungsbeispiele und Aspekte der Erfindung miteinander kombiniert werden. Insbesondere können die Merkmale nicht nur in den beschriebenen Kombinationen, sondern auch in anderen Kombinationen oder für sich genommen verwendet werden, ohne das Gebiet der Erfindung zu verlassen.

Beispielsweise wurden voranstehend verschiedene Techniken im Zusammenhang mit einer Lithium-Plating-Bestimmung für eine Batterie beschrieben. Solche Techniken können auch für individueller Blöcke der Batterie oder Zellen oder Zellgruppen der Batterie implementiert werden.

Ferner wurden voranstehend verschiedene Techniken beschrieben, bei denen Betriebswerte als Zeitreihen empfangen werden. Es wäre aber im Allgemeinen auch möglich, dass die Betriebswerte als aggregierte Daten empfangen werden, d.h. z.B. als Histogramme. Mit solchen aggregierten Daten können die zuvor beschriebenen Prozesse ebenfalls ausgeführt werden. Hierzu können beispielsweise aus simulierten Größen ebenfalls aggregierte Daten gebildet werden und die aggregierten simulierten Daten mit den aggregierten gemessenen Daten verglichen werden. Ergänzend oder alternativ kann aus aggregierten Daten wieder auf Zeitreihen geschlossen werden. Beispielsweise können Zeitreihen aus aggregierten Daten rekonstruiert werden, beispielsweise indem für einen ersten Satz an Referenzvorrichtungen über Testzyklen und/oder im Feldeinsatz Referenz-Zeitreihen bestimmt werden und aus diesen Zeitreihen abgeleitete aggregierte Referenz-Daten bestimmt werden. Dann können, beispielsweise für einen zweiten Satz an Vorrichtungen, aggregierte Daten erhoben werden und durch Vergleich von aggregierten Daten mit den aggregierten Referenz-Daten auf Basis der Referenz-Zeitreihen rekonstruierte Zeitreihen bestimmt werden. Die hier beschriebenen Verfahren können dann mit den rekonstruierten Zeitreihen durchgeführt werden. Auch andere oder abgewandelte Vorgehensweisen sind möglich. Solche Vorgehensweisen können der Vorteil bieten, dass nur ein geringer Anteil von Vorrichtungen, beispielsweise weniger als 1% einer Fahrzeugserie, eingerichtet sein muss, Zeitreihen zu erfassen und dennoch, beispielsweise auf Grundlage von bei Wartungsintervallen abgerufenen aggregierten Daten, auf individuelle Batteriezustände auch von den anderen Fahrzeugen der Serie, geschlossen werden kann.

## Patentansprüche

1. Verfahren zur Charakterisierung einer wieder aufladbaren Batterie (91-96), die ein Risiko für Lithium-Plating aufweist, umfassend:
Empfangen (1001) von Betriebswerten (41) der Batterie (91-96) als Zeitreihen, wobei die Betriebswerte der Batterie umfassen:
eine Klemmenspannung der Batterie ( U(t) ),
ein Batteriestrom der Batterie ( I(t) ),
Bestimmen (1002) einer modellierten Klemmenspannung ( USim(t) ) mit einem Modell der Batterie (400), basierend auf dem Batteriestrom ( I(t) ),
Vergleichen (1003) der modellierten Klemmenspannung ( USim(t) ) mit der Klemmenspannung ( U(t) ),
Bestimmen (1004, 1004a, 1004b) eines Lithium-Plating-Zustands der Batterie basierend auf dem Vergleichen.

2. Verfahren nach Anspruch 1, wobei das Vergleichen ferner umfasst:
Bestimmen einer Spannungs-Ladungs-Kurve (200) basierend auf der Klemmenspannung ( U(t) ) und dem Batteriestrom ( I(t) ),
Bestimmen einer modellierten Spannungs-Ladungs-Kurve (300) basierend auf der modellierten Klemmenspannung ( USim(t) ) und dem Batteriestrom,
Vergleichen der Spannungs-Ladungs-Kurve (200) mit der modellierten Spannungs-Ladungs-Kurve (300).

3. Verfahren nach einem der vorherigen Ansprüche, wobei das Vergleichen der modellierten Klemmenspannung mit der Klemmenspannung das Bestimmen eines Spannungsoffsets (Uoff) als Differenz zwischen der modellierten Klemmenspannung und der Klemmenspannung umfasst, der indikativ für den Lithium-Plating-Zustand ist.

4. Verfahren nach Anspruch 2 und Anspruch 3, wobei das Bestimmen des Lithium-Plating-Zustands basierend auf einer Breite (810) eines Plateaus (800) der Spannungs-Ladungs-Kurve quantifiziert wird, wobei das Plateau (800) basierend auf dem Spannungsoffset (Uoff) bestimmt wird.

5. Verfahren nach Anspruch 3 oder 4, wobei der Spannungsoffset (Uoff) zwischen 50 mV und 150 mV, insbesondere zwischen 80 mV und 120 mV ist.

6. Verfahren nach einem der vorherigen Ansprüche, wobei die Klemmenspannung und der Batteriestrom während eines Entladungsvorgangs und/oder eines Ladungsvorgangs der Batterie ermittelt wird.

7. Verfahren nach einem der vorherigen Ansprüche, wobei das Modell der Batterie (400) folgende Elemente (410, 411, 420-422, UOC) umfasst:
einen Ersatzschaltkreis (410, 411) der Batterie, die mindestens einen Widerstand (R0) und
eine ideale Spannungsquelle (UOC) umfasst,
und wobei das Verfahren weiterhin umfasst:
Bestimmen einer Dimensionierung von mindestens einem Element des Modells der Batterie (410, 411, 420-422, UOC) basierend auf mindestens einer Zustandsgröße (900) der Batterie.

8. Verfahren nach Anspruch 7, wobei das Modell der Batterie (400) ferner umfasst:
mindestens ein RC-Glied (420, 421, 422) und/oder
mindestens eine Hysterese-Element, welches eingerichtet ist, ein Hystereseverhalten der Batterie zu modellieren.

9. Verfahren nach einem der vorherigen Ansprüche, wobei mindestens ein Element des Modells der Batterie von mindestens einer Zustandsgröße abhängig ist.

10. Verfahren nach Anspruch 9,
wobei die mindestens eine Zustandsgröße ausgewählt ist aus:
Temperatur der Umgebung der Batterie,
Temperatur der Batterie,
einem Ladezustand, State of Charge, SoC, der Batterie,
einem Alterungszustand der Batterie,
einer Ereignishistorie der Batterie,
einer Stromrate einer Belastung der Batterie.

11. Verfahren nach einem der vorherigen Ansprüche, wobei das Verfahren zusätzlich umfasst:
Bereitstellen einer Konfiguration für ein Batteriemanagementsystem basierend auf dem Lithium-Plating-Zustand der Batterie.

12. Computerprogramm mit einem Programmcode, der, wenn er auf einem Prozessor ausgeführt wird, bewirkt, dass das Verfahren nach einem der Ansprüche 1-11 durchgeführt wird.

13. System (80), umfassend:
mindestens eine Vorrichtung (100)) mit einer Batterie , wobei die Vorrichtung eingerichtet ist, Betriebswerte an einen Server (81) zu übertragen, wobei die Betriebswerte umfassen:
eine Klemmenspannung der Batterie als Zeitreihe und einen Batteriestrom der Batterie als Zeitreihe,
und
einen Server (81), der eingerichtet ist, die Betriebswerte der mindestens einen Vorrichtung (100) zu empfangen und damit das Verfahren nach einem der Ansprüche 1-11 auszuführen.

14. Server, der eingerichtet ist, Betriebswerten (41) einer Batterie (91-96) als Zeitreihen zu empfangen und damit ein Verfahren gemäß einem der Ansprüche 1-11 auszuführen,
wobei die Betriebswerte der Batterie umfassen:
eine Klemmenspannung der Batterie ( U(t) ),
ein Batteriestrom der Batterie ( I(t) ).

## Claims

1. Method for characterizing a rechargeable battery (91-96) which is at risk of lithium plating, comprising:
receiving (1001) operating values (41) of the battery (91-96) as time series, wherein the operating values of the battery comprise:
a terminal voltage of the battery (U(t)),
a battery current of the battery (I(t)),
determining (1002) a modelled terminal voltage (Usim(t)) using a model of the battery (400) on the basis of the battery current (I(t)),
comparing (1003) the modelled terminal voltage (Usim(t)) with the terminal voltage (U(t)),
determining (1004, 1004a, 1004b) a lithium plating state of the battery on the basis of the comparison.

2. Method according to Claim 1, wherein the comparison also comprises:
determining a voltage/charge curve (200) on the basis of the terminal voltage (U(t)) and the battery current (I(t)),
determining a modelled voltage/charge curve (300) on the basis of the modelled terminal voltage (Usim(t)) and the battery current,
comparing the voltage/charge curve (200) with the modelled voltage/charge curve (300).

3. Method according to one of the preceding claims, wherein the comparison of the modelled terminal voltage with the terminal voltage comprises determining a voltage offset (Uoff) as the difference between the modelled terminal voltage and the terminal voltage, which voltage offset is indicative of the lithium plating state.

4. Method according to Claim 2 and Claim 3, wherein the determination of the lithium plating state is quantified on the basis of a width (810) of a plateau (800) of the voltage/charge curve, wherein the plateau (800) is determined on the basis of the voltage offset (Uoff).

5. Method according to Claim 3 or 4, wherein the voltage offset (Uoff) is between 50 mV and 150 mV, in particular between 80 mV and 120 mV.

6. Method according to one of the preceding claims, wherein the terminal voltage and the battery current are determined during a discharging operation and/or a charging operation of the battery.

7. Method according to one of the preceding claims, wherein the model of the battery (400) comprises the following elements (410, 411, 420-422, UOC):
an equivalent circuit (410, 411) of the battery comprising at least one resistor (R0) and
an ideal voltage source (UOC),
and wherein the method also comprises:
determining a dimensioning of at least one element of the model of the battery (410, 411, 420-422, UOC) on the basis of at least one state variable (900) of the battery.

8. Method according to Claim 7, wherein the model of the battery (400) also comprises:
at least one RC element (420, 421, 422) and/or
at least one hysteresis element which is configured to model a hysteresis behaviour of the battery.

9. Method according to one of the preceding claims, wherein at least one element of the model of the battery is dependent on at least one state variable.

10. Method according to Claim 9,
wherein the at least one state variable is selected from:
temperature of the environment of the battery,
temperature of the battery,
a state of charge, SoC, of the battery,
a state of health of the battery,
an event history of the battery,
a current rate of a load on the battery.

11. Method according to one of the preceding claims, wherein the method additionally comprises:
providing a configuration for a battery management system on the basis of the lithium plating state of the battery.

12. Computer program having a program code which, when executed on a processor, causes the method according to one of Claims 1-11 to be carried out.

13. System (80) comprising:
at least one apparatus (100) having a battery, wherein the apparatus is configured to transmit operating values to a server (81), wherein the operating values comprise:
a terminal voltage of the battery as a time series and a battery current of the battery as a time series,
and
a server (81) which is configured to receive the operating values of the at least one apparatus (100) and therefore to carry out the method according to one of Claims 1-11.

14. Server which is configured to receive operating values (41) of a battery (91-96) as a time series and therefore to carry out a method according to one of Claims 1-11,
wherein the operating values of the battery comprise:
a terminal voltage of the battery (U(t)),
a battery current of the battery (I(t)).

## Revendications

1. Procédé de caractérisation d'une batterie rechargeable (91-96) présentant un risque de placage de lithium, comprenant :
la réception (1001) de valeurs de fonctionnement (41) de la batterie (91-96) sous forme de séries temporelles, les valeurs de fonctionnement de la batterie comprenant :
une tension (U(t)) aux bornes de la batterie,
un courant de batterie (l(t)) de la batterie,
la détermination (1002) d'une tension aux bornes modélisée (USim(t)) à l'aide d'un modèle de la batterie (400), sur la base du courant de batterie (1(t)),
la comparaison (1003) de la tension aux bornes modélisée (USim(t)) à la tension aux bornes (U(t)),
la détermination (1004, 1004a, 1004b) d'un état de placage de lithium de la batterie sur la base de la comparaison.

2. Procédé selon la revendication 1, dans lequel la comparaison comprend en outre :
la détermination d'une courbe tension-charge (200) sur la base de la tension aux bornes (U(t)) et du courant de batterie (1(t)),
la détermination d'une courbe tension-charge modélisée (300) sur la base de la tension aux bornes modélisée (USim(t)) et du courant de batterie,
la comparaison de la courbe tension-charge (200) à la courbe tension-charge modélisée (300).

3. Procédé selon l'une des revendications précédentes, dans lequel la comparaison de la tension aux bornes modélisée à la tension aux bornes comprend la détermination d'un décalage de tension (Uoff) comme différence entre la tension aux bornes modélisée et la tension aux bornes, laquelle différence indique l'état de placage de lithium.

4. Procédé selon la revendication 2 et la revendication 3, dans lequel la détermination de l'état de placage de lithium est quantifiée sur la base d'une largeur (810) d'un plateau (800) de la courbe tension-charge, le plateau (800) étant déterminé sur la base du décalage de tension (Uoff).

5. Procédé selon la revendication 3 ou 4, dans lequel le décalage de tension (Uoff) est compris entre 50 mV et 150 mV, en particulier entre 80 mV et 120 mV.

6. Procédé selon l'une des revendications précédentes, dans lequel la tension aux bornes et le courant de batterie sont définis pendant un processus de décharge et/ou un processus de charge de la batterie.

7. Procédé selon l'une des revendications précédentes, dans lequel le modèle de la batterie (400) comprend les éléments (410, 411, 420-422, UOC) suivants :
un circuit de commutation équivalent (410, 411) de la batterie, laquelle comprend au moins une résistance (R0) et
une source de tension idéale (UOC),
et le procédé comprenant en outre :
la détermination d'un dimensionnement d'au moins un élément du modèle de la batterie (410, 411, 420-422, UOC) sur la base d'au moins une variable d'état (900) de la batterie.

8. Procédé selon la revendication 7, dans lequel le modèle de la batterie (400) comprend en outre :
au moins un circuit RC (420, 421, 422) et/ou au moins un élément d'hystérésis qui est configuré pour modéliser un comportement d'hystérésis de la batterie.

9. Procédé selon l'une des revendications précédentes, dans lequel au moins un élément du modèle de la batterie est dépendant d'au moins une variable d'état.

10. Procédé selon la revendication 9,
dans lequel l'au moins une variable d'état est sélectionnée parmi :
la température de l'environnement de la batterie,
la température de la batterie,
un état de charge (State of Charge, SoC) de la batterie,
un état de vieillissement de la batterie,
un historique d'événements de la batterie,
un taux de courant d'une charge de la batterie.

11. Procédé selon l'une des revendications précédentes, le procédé comprenant en outre :
la fourniture d'une configuration pour un système de gestion de batterie sur la base de l'état de placage de lithium de la batterie.

12. Programme informatique comportant un code de programme qui, lorsqu'il est exécuté sur un processeur, provoque la mise en œuvre du procédé selon l'une des revendications 1 à 11.

13. Système (80) comprenant :
au moins un dispositif (100) comportant une batterie, le dispositif étant configuré pour transmettre des valeurs de fonctionnement à un serveur (81), les valeurs de fonctionnement comprenant :
une tension aux bornes de la batterie en tant que série temporelle et un courant de batterie de la batterie en tant que série temporelle,
et
un serveur (81) qui est configuré pour recevoir les valeurs de fonctionnement de l'au moins un dispositif (100) et ainsi exécuter le procédé selon l'une des revendications 1 à 11.

14. Serveur configuré pour recevoir des valeurs de fonctionnement (41) d'une batterie (91-96) sous la forme de séries temporelles et ainsi exécuter un procédé selon l'une des revendications 1 à 11,
les valeurs de fonctionnement de la batterie comprenant :
une tension (U(t)) aux bornes de la batterie,
un courant de batterie (l(t)) de la batterie.
